## Europäisches Patentamt
## European Patent Office
## Office européen des brevets

(11) Veröffentlichungsnummer: **0 125 413**
**B1**

(12) **EUROPÄISCHE PATENTSCHRIFT**

(45) Veröffentlichungstag der Patentschrift: **18.07.90**

(51) Int. Cl.⁵: **G 01 D 5/245, H 03 M 1/00**

(21) Anmeldenummer: **84102609.9**

(22) Anmeldetag: **09.03.84**

(54) Inkrementale Wegmesseinrichtung.

(30) Priorität: **22.03.83 DE 3310348**

(43) Veröffentlichungstag der Anmeldung:
**21.11.84 Patentblatt 84/47**

(45) Bekanntmachung des Hinweises auf die
Patenterteilung:
**18.07.90 Patentblatt 90/29**

(84) Benannte Vertragsstaaten:
**DE FR**

(56) Entgegenhaltungen:
**EP-A-0 033 902**
**GB-A-2 057 119**
**US-A-3 638 186**
**US-A-3 811 648**

(73) Patentinhaber: **Siemens Aktiengesellschaft**
**Wittelsbacherplatz 2**
**D-8000 München 2 (DE)**

(72) Erfinder: **Röhrle, Josef, Dipl.-Ing.**
**Am Kohlberg 12**
**D-8521 Hessdorf (DE)**

Courier Press, Leamington Spa, England.

## Beschreibung

Die Erfindung bezieht sich auf eine inkrementale Wegmeßeinrichtung, bei der die Passage und Passagerichtung einer Folge von aus einer Ausgangsstellung heraus gegenüber mindestens einem Sensor bewegbaren Wegmarken durch diesen detektierbar ist, wobei demgemäß vom Sensor auslösbare Ein- und Auszählimpulse einer ersten Vorwärts-Rückwärts-Zähleinrichtung zuführbar sind, deren Zählvolumen dem zu messenden Gesamtweg angepaßt ist und deren Zählbeginn mit einer Ausgangsstellung korrespondiert, wobei jeweils nach einer vorgegebenen Anzahl von Wegmarken durch eine Referenzwegmarke ein Synchronisiersignal auslösbar ist und wobei die Ein- und Auszählimpulse auch einer zweiten, zyklisch zählenden Vorwärts-Rückwärts-Zähleinrichtung zuführbar ist.

Inkrementale Wegmeßeinrichtungen haben sich auf alle Gebieten des Maschinenbaus als robust und dabei nahezu jeden Anwendungsfall leicht anpaßbar erwiesen (DE-OS 29 39 000). Es ist bei solchen Wegmeßeinrichtungen jedoch möglich, daß beim Vorhandensein elektrischer Störer von diesen ausgelöste Störimpulse das Zählergebnis bleibend verfälschen.

Wenn das Synchronisiersignal während eines zu erfassenden Weges einer Linear- oder Rotationsbewegung jedoch nicht nur einmal, sondern periodisch durch mehrere hintereinander angeordnete oder mindestens eine rotierende Wegmarke ausgelöst wird, ist es zum Eliminieren bleibender Verfälschungen möglich, bei Kenntnis der Anzahl der Wegmarken zwischen den aufeinanderfolgenden Synchronisiersignalen jeweils mit dem Auftreten eines Synchronisiersignals die Zähleinrichtung in eine definierte Ausgangsstellung zurückzusetzen. Die Dauer der Verfälschung ist damit zwar auf die Dauer einer Periode beschränkt, jedoch ist in diesem Fall die Kapazität der Wegmeßeinrichtung jeweils auf den Abstand zwischen zwei Referenzwegmarken beschränkt, es sei denn, daß eine weitere Zähleinrichtung zum zusätzlichen Registrieren der Rücksetzvorgänge vorgesehen ist. Das Zusammenspiel zweier derartiger Zähleinrichtungen erfordert jedoch einen nicht unerheblichen technischen Aufwand, damit sichergestellt ist, daß es bei einer Überlappung des Rücksetzens mit einem Zählimpuls nicht zu Fehlzählungen kommt.

Eine Einrichtung der eingangs genannten Art ist aus der EP-A-0 033 902 bekannt, die eine für manche Zwecke ausreichende Maßnahme zum Überwachen der periodischen Impulsfolge aufzeigt.

Aufgabe der Erfindung ist es, eine Wegmeßeinrichtung der eingangs genannten Gattung derart auszubilden, daß die Zähleinrichtung beim periodischen Auftreten von Referenzwegmarken inkremental den zu erfassenden Weg mißt, ohne daß ein periodisches Rücksetzen der Zähleinrichtung erfolgt.

Gemäß der Erfindung wird diese Aufgabe dadurch gelöst, daß das Zählvolumen der zweiten, zyklisch zählenden Vorwärts-Rückwärts-Zähleinrichtung einem ganzzahligen Teiler der vorgegebenen Anzahl von Wegmarken zwischen aufeinanderfolgenden Referenzmarken entspricht und daß Schaltmittel zum Vergleich des Zählerstandes der zweiten Vorwärts-Rückwärts-Zähleinrichtung zum jeweiligen Zeitpunkt des Vorliegens jeweils aufeinanderfolgender Synchronisiersignale und zum Ermitteln eines dem Vergleichsergebnis entsprechenden Differenzsignals vorgesehen sind. Für den Fall, daß beim Erfassen von Drehbewegungen handelsübliche dekadische Geber mit 1000, 2500 oder 5000 Impulsen zwischen den Referenzwegmarken vorgesehen sind, erweist es sich als zweckmäßig, wenn die zweite Vorwärts-Rückwärts-Zähleinrichtung eine Kapazität von 10 Stellen aufweist. Für den Fall, daß handelsübliche duale Geber mit 1024, 2048 oder 4096 Impulsen zwischen den Referenzwegmarken vorgesehen sind, ist es günstig, wenn Zähler mit einem Zählvolumen von 16 Stellen zum Einsatz kommen.

Eine erste vorteilhafte Ausbildung der Erfindung ist dadurch gekennzeichnet, daß entsprechend dem Differenzsignal der Zählerstand der ersten Zähleinrichtung in einer dieser nachgeschalteten Verarbeitungseinrichtung korrigierbar ist. Dadurch kann auf eine fortlaufende Anzeige bzw Protokollierung des Vergleichsergebnisses verzichtet werden.

Für Testfälle, z.B. beim Inbetriebsetzen oder Warten der Wegmeßeinrichtung, erweist es sich allerdings als vorteilhaft, wenn das Differenzsignal einer Anzeigeeinrichtung zur Darstellung des Vergleichsergebnisses zuführbar ist.

Ein Ausführungsbeispiel der Erfindung ist in der Zeichnung dargestellt und wird im folgenden näher erläutert.

Dabei zeigen:

Fig. 1 ein Blockschaltbild der Wegmeßeinrichtung,

Fig. 2 Diagramme zum Veranschaulichen der Funktion der Einrichtung.

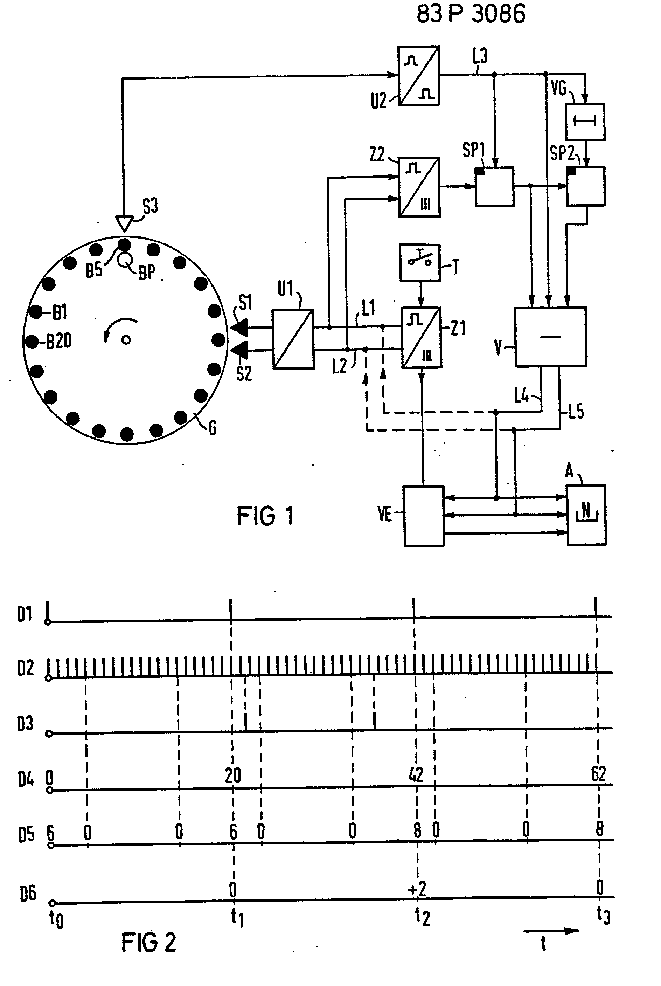

Die Darstellung gemäß Fig. 1 zeigt einen entgegen dem Uhrzeigersinn rotierenden Geber G der Wegmeßeinrichtung, der als Wegmarken gleichmäßig über seinen Umfang verteilt Beeinflussungspunkte B1 bis B20 aufweist. Die Beeinflussungspunkte B1 bis B20 sind jeweils durch ausgefüllte Kreise symbolisiert. Ferner weist der Geber als Referenzwegmarke einen weiteren Beeinflussungspunkt BP am Ort des Beeinflussungspunktes B5 auf. Dieser Beeinflussungspunkt BP ist durch einen offenen Kreis symbolisiert. Die Beeinflussungspunkte B1 bis B20 wirken auf Sensoren S1 und S2 ein, die jeweils durch ein ausgefülltes Dreieck symbolisiert sind. Mit Hilfe eines von den Sensoren S1 und S2 angesteuerten Umsetzers U1 wird jeweils die Passage und die Passagerichtung eines der Beeinflussungspunkte B1 bis B20 gegenüber der Anordnung aus den Sensoren S1 und S2 detektiert und bei der jeweiligen Passage eines der Beeinflussungspunkte B1 bis B20 entgegen dem Uhrzeigersinn wird durch den Umsetzer U1 ein Impuls auf einer Leitung L1 ausgelöst, während bei einer Beeinflussung der Anordnung aus den Sensoren S1 und S2 durch einen der Beeinflussungspunkte B1 bis B20 im Uhrzeigersinn auf einer Leitung L2 ein Impuls ausgelöst wird. Es wäre auch möglich, anstelle der zwei Sensoren S1 und S2 nur einen einzigen Sensor zu verwenden, jedoch wäre dann der Geber G mit zwei gegeneinander versetzten Spuren von Beeinflussungspunkten zu versehen.

Der Beeinflussungspunkt BP wirkt auf einen Sensor S3, ein, der durch ein offenes Dreieck symbolisiert ist. Mit Hilfe eines Umsetzers U2 wird die Passage des Beeinflussungspunktes BP gegenüber dem Sensor S3 durch einen Impuls auf einer Leitung L3 angezeigt.

Die Impulse auf den Leitungen L1 und L2 werden einer Vorwärts-Rückwärts-Zähleinrichtung, im folgenden Zähler Z1 genannt, zugeführt, der je nachdem, ob ein Impuls auf der Leitung L1 oder der Leitung L2 vorliegt, fort- oder rückgeschaltet wird. Das Zählergebnis des Zählers Z1, das als Maß für die ab einem durch Betätigen einer Taste T vorgegebenem Zeitpunkt t0 erfaßten Beeinflussungspunkte B1 bis B20 dient, wird einer Verarbeitungseinrichtung VE weitergemeldet. Dieses Ergebnis kann auch mit Hilfe einer numerischen Anzeigeeinrichtung A optisch dargestellt werden.

Die Kapazität des Zählers Z1 ist dabei so gewählt, daß die betrieblich zu erwartende Anzahl von Beeinflussungen, d.h. Beeinflussungen der Sensoren S1 und S2 durch die Beeinflussungspunkte B1 bis B20 während des zu messenden Weges- in der Regel eine größere Anzahl von Umdrehungen des Gebers G - zuzüglich der höchsten zu erwartenden Anzahl additiv wirkender Störimpulse während der Zeitspanne zwischen zwei aufeinanderfolgenden Beeinflussungen des Sensors S3, mit Sicherheit nicht überschritten wird.

Für den Fall daß sehr große-Wegstrecken zu messen sind wobei dann die Kapazität des Zählers Z1 überschritten wird, ist es aber auch möglich, das Zählergebnis des Zählers Z1 zyklisch abzufragen und die erfaßten Teilwegen in der Verarbeitungseinrichtung VE zu addieren. Dabei muß während jeder Zählperiode des Zählers Z1 mindestens eine Abfrage erfolgen. Ferner muß in der Verarbeitungseinrichtung VE das Zählvolumen des Zählers Z1 bekannt sein.

Die Impulse auf den Leitungen L1 und L2 gelangen ferner an eine zweite, zyklisch zählende Vorwärts-Rückwärts-Zähleinrichtung, im folgenden als Zähler Z2 bezeichnet. Das Zählvolumen des Zählers Z2 entspricht einem natürlichen ganzen Bruchteil der Anzahl von Wegmarken zwischen dem Auftreten der Synchronisiersignale, d.h. der Beeinflussung des Sensors S3 durch den Beeinflussungspunkt BP. Bei zwanzig Beeinflussungspunkten B1 bis B20 und einem angenommenen Bruchteil 1/2 beträgt das Volumen des Zählers Z2 "zehn". Um äußere additiv wirkende Störimpulse sicher auswerten zu können, muß das Zählvolumen des Zählers Z2 größer sein, als die höchste zu erwartende Anzahl additiv wirkender Störimpulse zwischen zwei unmittelbar aufeinanderfolgenden Synchronisiersignalen.

Das Zählergebnis des Zählers Z2 wird beim Auftreten eines Impulses auf der Leitung L3, d.h. eines Synchronisierimpulses durch Passage des Beeinflussungspunktes BP gegenüber dem Sensor S3, einem Speicher SP1 gemeldet, der seinen Inhalt auf Grund der Wirkungsweise eines Verzögerungsgliedes VG zeitverzögert zu diesem Impuls an einen Speicher SP2 weitergibt. Die Verzögerungszeit ist dabei auf jeden Fall kleiner als die kürzeste Zeitspanne zwischen zwei aufeinanderfolgenden Beeinflussungen. Damit steht im Speicher SP1 beim Auftreten des Impulses auf der Leitung L3 jeweils das aktuelle Zählergebnis und im Speicher SP2 das jeweils vorangegangene Zählergebnis.

Zum Zeitpunkt des Auftretens eines Impulses auf der Leitung L3 wird ferner eine Vergleichseinrichtung V wirksamgeschaltet, die den Inhalt der Speicher SP1 und SP2 miteinander vergleicht und das Vergleichsergebnis über Leitungen L4 bzw L5 als positiven bzw. negativen Wert zum einen der Verarbeitungseinrichtung VE meldet, die dementsprechend das vom Zähler Z1 erhaltene Ergebnis korrigieren kann, und zum anderen der Anzeigeeinrichtung A meldet, die das Vergleichsergebnis unmittelbar anzeigen kann.

Anstelle eines Übermittelns des Vergleichsergebnisses an die Verarbeitungseinrichtung VE wäre es auch möglich, wie durch gestrichelte Linien angedeutet, eine dem Vergleichsergebnis entsprechende Anzahl von Korrekturimpulsen dem Zähler Z1 zuzuführen, wobei jedoch sichergestellt sein müßte, daß die Korrekturimpulse nicht mit den Impulsen auf den Leitungen L1 und L2 kollidieren.

In der Darstellung gemäß Fig.2 sind sechs Diagramme D1 bis D6 dargestellt, die Impulsverläufe und Zählergebnisse im Verlauf von drei Umdrehungen des Gebers G darstellen. Die Zeitmaßstäbe der Diagramme D1 bis D6 sind gleich gewählt und alle Diagramme D1 bis D6 beginnen zu einem durch einen offenen Kreis dargestellten gleichen Zeitpunkt t0. An diesem Zeitpunkt erfolgt eine Beeinflussung des Sensors S3 durch den Beeinflussungspunkt BP. Der Geber G (Figur 1) rotiert entgegen dem Uhrzeigersinn mit konstanter Geschwindigkeit. Eine erneute Beeinflussung des Sensors S3 durch den Beeinflussungspunkt BP erfolgt zu den Zeiten t1, t2 und t3. Dies ist im Diagramm D1, das die Impulse auf der Leitung L3 zeigt, verdeutlicht. Da angenommen ist, daß der Geber G seine Drehrichtung nicht ändert, werden durch die 20 Beeinflussungspunkte B1 bis B20 vom Zeitpunkt t0 bis zum Zeitpunkt t1 20 Impulse ausgelöst. Dies ist im linken Drittel vom Diagramm D2 dargestellt.

Im Diagramm D4, das den Zählerstand des Zählers Z1 angibt, ist ersichtlich, daß der Zählerstand zum Zeitpunkt t1 "20" beträgt. Die Korrespondenz zwischen dem zweiten Impuls im Diagramm D1 zum Zeitpunkt t1 mit dem erwähnten Zählerstand ist wie auch alle weiteren Korrespondenzen innerhalb der Diagramme D1 bis D6 jeweils durch eine gestrichelte Linie angedeutet.

Während der Zähler Z1 aus einer Ausgangsstellung "0" heraus zum Zeitpunkt t0 gestartet wird, besteht eine solche feste Zuordnung des Zählerstandes des Zählers Z2 mit dem Zeitpunkt t0 nicht. Im Diagramm D5 ist der Zählerstand des Zählers Z2 gezeigt. Dieser bis "10" zählende Zähler Z2 möge beispielsweise zum Zeitpunkt t0 bei "6" gestartet sein. Nach Auftreten von vier Impulsen auf der Leitung L1 - siehe Diagramm D2 gelangt der Zähler Z2 daher wieder in seine Grundstellung, nach Auftreten von 14 Impulsen ebenfalls und nach Auftreten von 20 Impulsen bis zum Zeitpunkt t1 erreicht er wieder den Zählerstand "6". Ein Vergleich des Zählerstandes des Zählers Z2 zum Zeitpunkt t1 mit demjenigen zum Zeitpunkt t0 zeigt, daß in beiden Fällen ein gleicher Zählerstand vorliegt. Die Differenz der Zählerstände beträgt zum Zeitpunkt t1 also "0". Dies ist im Diagramm D6 verdeutlicht, welches das jeweilige Vergleichsergebnis zu den Zeiten t0, t1 und t2 sowie die Zeitpunkte, zu denen der Zähler Z2 den Zählerstand "0" einnimmt, zeigt.

Wenn bis zum nächsten Auftreten einer Referenzwegmarke beispielsweise zwei Störimpulse, wie sie im Diagramme D3 dargestellt sind, auftreten, führt dies dazu, daß der Zähler Z1 zum Zeitpunkt t2 einen Zählerstand "42" erreicht hat. Der Zähler Z2 hat - bedingt durch die zwei zusätzlichen Störimpulsen - zum Zeitpunkt t2 nicht einen Zählerstand " 6", sondern einen Zählerstand "8" erreicht. Ein zum Zeitpunkt t2 erfolgender Vergleich der Zählerstände des Zählers Z2 zum Zeitpunkte t2 und t1 ergibt eine Differenz "+2". Damit ist die Anzahl der störend während der zweiten Umdrehung des Gebers G zwischen den Zeitpunkten t1 und t2 in das System eingedrungenen Impulse detektiert und kann für die weitere Verarbeitung berücksichtigt werden.

Sofern keine weiteren Störimpulse auftreten, wird während der nächsten Umdrehung des Gebers G vom Zeitpunkt t2 bis zum Zeitpunkt t3 der Zähler Z1 ein Zählergebnis "62" aufweisen, der Zähler Z2 ein Zählergebnis "8". Eine Differenzbildung der Zählergebnisse des Zählers Z2 zum Zeitpunkt t3 ergibt, daß am Zeitpunkt t3 der gleiche Zählerstand vorliegt wie am Zeitpunkt t2 und daß damit offensichtlich keine Störimpulse während der dritten Umdrehung des Gebers G in das System eingedrungen sind.

## Patentansprüche

1. Inkrementale Wegmeßeinrichtung, bei der die Passage und Passagerichtung einer Folge von aus einer Ausgangsstellung heraus gegenüber mindestens einem Sensor bewegbaren Wegmarken durch diesen detektierbar ist, wobei demgemäß vom Sensor auslösbare Ein- und Auszählimpulse einer ersten Vorwärts-Rückwärts-Zähleinrichtung zuführbar sind, deren Zählvolumen dem zu messenden Gesamtweg angepaßt ist und deren Zählbeginn mit einer Ausgangsstellung korrespondiert, wobei jeweils nach einer vorgegebenen Anzahl von Wegmarken durch eine Referenzwegmarke ein Synchronisiersignal auslösbar ist und wobei die Ein- und Auszählimpulse auch einer zweiten, zyklisch zählenden Vorwärts-Rückwärts-Zähleinrichtung zuführbar sind, dadurch gekennzeichnet, daß das Zählvolumen der zweiten, zyklisch zählenden Vorwärts-RückwärtsZähleinrichtung (Z2) einem ganzzahligen Teiler der vorgegebenen Anzahl von Wegmarken zwischen aufeinanderfolgenden Referenzmarken entspricht und daß Schaltmittel (SP1, SP2, V; FIG 1) zum Vergleichen des Zählerstandes der zweiten Vorwärts-Rückwärts-Zähleinrichtung (Z2) zum jeweiligen Zeitpunkt des Vorliegens jeweils aufeinanderfolgender Synchronisiersignale und zum Ermitteln eines dem Vergleichsergebnis entsprechenden Differenzsignals vorgesehen sind.

2. Einrichtung nach Anspruch 1, dadurch gekennzeichnet, daß entsprechend dem Differenzsignal der Zählerstand der ersten Zähleinrichtung (Z1; Figur 1) in einer dieser nachgeschalteten Verarbeitungseinrichtung (VE; Figur 1) korrigierbar ist.

3. Einrichtung nach Anspruch 1 oder 2, dadurch gekennzeichnet, daß das Differenzsignal einer Anzeigeeinrichtung (A; Figur 1) zur Darstellung des Vergleichsergebnisses zuführbar ist.

## Revendications

1. Dispositif de mesure incrémental de déplacement, dans lequel le passage et la direction de passage d'une suite de marques de distance, qui peuvent se déplacer à partir d'une position initiale par rapport à au moins un capteur, peuvent être détectés par ce capteur, et dans lequel par conséquent des impulsions de comptage progressif et de comptage régressif, pouvant être déclenchées par le capteur, peuvent être envoyées à un premier dispositif de comptage progressif/régressif, dont la capacité de comptage est adaptée au déplacement global devant être mesuré et dont le début du comptage correspond à une position de départ, et dans lequel un signal de synchronisation peut être déclenché respectivement après un nombre prédéterminé de marques de distance, par une marque de déplacement de référence, et dans lequel les impulsions de comptage progressif et de comptage régressif peuvent être envoyées également à un second dispositif de comptage progressif/régressif réalisant un comptage cyclique, caractérisé par le fait que la capacité de comptage du second dispositif de comptage progressif/régressif (Z2) réalisant un comptage cyclique correspond à un diviseur entier du nombre prédéterminé de marques de distance entre des marques de référence successives, et qu'il est prévu des moyens de commutation (SP1, SP2, V; figure 1) servant à comparer l'état de comptage du second compteur progressif/régressif (Z2) à un instant respectif de l'apparition de signaux successifs respectifs de synchronisation et à déterminer un signal de différence correspondant au résultat de la comparaison.

2. Dispositif suivant la revendication 1, caractérisé par le fait qu'en fonction du signal de référence, l'état de comptage du premier dispositif de comptage (Z1; figure 1) peut être corrigé dans un dispositif de traitement (VE; figure 1) branché en aval de ce dispositif de comptage.

3. Dispositif suivant la revendication 1 ou 2, caractérisé par le fait que le signal de différence peut être envoyé à un dispositif d'affichage (A; figure 1) servant à représenter le résultat de la comparaison.

**Claims**

1. Incremental position measuring device, in which the passing and direction of passing of a series of position marks which can move from an initial position, in relation to at least one sensor, can be detected by this sensor, and in which counting-in and counting-out pulses which can be triggered correspondingly by the sensor can be fed to a first up-down counting device, the counting capacity of which is matched to the total travel to be measured, and the start of counting of which corresponds to an initial position, with a synchronising signal which is capable of being triggered each time after a specified number of position marks by a reference position mark, and with the counting-in and counting-out pulses also capable of being fed to a second up-down counting device which counts cyclically, characterised in that the counting capacity of the second, cyclically counting up-down counting device (Z2) corresponds to an integer divisor of the specified number of position marks between successive reference marks, and in that switching means (SP1, SP2, V; Figure 1) are provided for comparing the count of the second up-down counting device (Z2) with the respective time of the presence of each of the successive synchronising signals, and for determining a differential signal corresponding to the comparison result.

2. Device according to claim 1, characterised in that, according to the differential signal, the count of the first counting device (Z1; Figure 1) can, be corrected in a processing device (VE; Figure 1) connected after this counting device (Z1; Figure 1).

3. Device according to claim 1 or 2, characterised in that the differential signal can be fed to a display device (A; Figure 1) for representing the comparison result.

83 P 3086

FIG 1

FIG 2

1